# EUROPEAN PATENT APPLICATION

(11) **EP 4 108 814 A1**
(43) Date of publication of application: **28.12.2022**
(21) Application number: 20931628.0
(22) Date of filing: 25.09.2020
(51) Int. Cl.: C30B 33/06, B28D 5/04

(54) **METHOD FOR PREPARING LARGE-SIZE SINGLE CRYSTAL**

(30) Priority: 17.04.2020 CN 202010306276
(71) Applicant: The 13th Research Institute Of China Electronics Technology Group Corporation, Shijiazhuang, Hebei 050051 (CN); China Nanhu Academy of Electronics and Information Technology, Jiaxing, Zhejiang 314000 (CN)
(72) Inventor: WANG, Shujie, Shijiazhuang, Hebei 050051 (CN); SUN, Niefeng, Shijiazhuang, Hebei 050051 (CN); SHI, Yanlei, Shijiazhuang, Hebei 050051 (CN); SHAO, Huimin, Shijiazhuang, Hebei 050051 (CN); LI, Xiaolan, Shijiazhuang, Hebei 050051 (CN); WANG, Yang, Shijiazhuang, Hebei 050051 (CN); FU, Lijie, Shijiazhuang, Hebei 050051 (CN); XU, Senfeng, Shijiazhuang, Hebei 050051 (CN); JIANG, Jian, Shijiazhuang, Hebei 050051 (CN); LIU, Huisheng, Shijiazhuang, Hebei 050051 (CN); SUN, Tongnian, Shijiazhuang, Hebei 050051 (CN)
(74) Representative: Sun, Yiming
(86) International application number: PCT/CN2020/117592
(87) International publication number: WO 2021/208365

(57) **Abstract**

A method for preparing a large-size monocrystal belongs to the field of semiconductor material preparation, particularly relating to a method for preparing a large-size monocrystal from a plurality of small-size monocrystals by means of solid-state joining. comprising the steps of: material selection: selecting semiconductor single crystal blocks with generally similar physical properties and basically the same crystal orientation accuracy of the splicing plane; splicing plane processing: subjecting the splicing plane of the semiconductor monocrystal block to orientation, polishing and acid washing treatments; monocrystal splicing: abutting the splicing planes of the processed monocrystal blocks; and monocrystal joining: applying a certain pressure in a vacuum clean environment or in a volatile atmosphere on the spliced monocrystal blocks to complete the preparation of the large-size monocrystal. It has the following advantageous effects: 1, the small-sized monocrystal blocks can be joined to prepare a large-size monocrystal; 2, the equipment is simple; 3, the control of the preparation process is simple; and 4, a monocrystal of any size can be prepared theoretically.

## Description

### Technical Field

The present invention belongs to the field of semiconductor material preparation, and particularly relates to a method for preparing a large-size monocrystal from a plurality of small-size monocrystals by means of solid-state joining.

### Background Art

Compound semiconductor materials, as one of the important basic supporting technologies for the development of the electronic information industry technology system, are widely used in optical fiber communication, mobile communication, navigation, detection and other fields. They have become a hot spot for the development of various countries. Compound semiconductor monocrystal substrate is the basis for the preparation of various types of electronic devices. The larger the size of semiconductor monocrystal, the lower the cost of the prepared devices. The size of semiconductor monocrystal substrate reflects the competitiveness of the development of the semiconductor industry in a country.

However, the larger the size of the semiconductor monocrystal substrate, the more difficult it is to prepare using conventional methods: larger size of monocrystal furnace equipment, higher requirements for stability and symmetry of monocrystal growth temperature field, and higher instrument requirements for the equipment. At the same time, the size of the crucible will increase accordingly. In order to establish a temperature gradient, the temperature of the crucible edge will become higher and higher, which would reduce the strength of the crucible. Even worse, the crucible cannot withstand high temperatures and contaminates the melt. At the same time, the utilization of energy will be reduced accordingly. Therefore, from the point of view of equipment and consumables, more and more problems are encountered only by enlarging the furnace body, increasing the size of the insulation and heating device, the size of the crucible and the size of the furnace body without limit.

Micro defects such as dislocations and inclusions can seriously affect the quality and yield of subsequent devices. Twinning and polycrystallization in compound semiconductors are unacceptable macro defects. Dislocations and twinning/polycrystallization are contradictory. The reduction of dislocations requires a reduction of the temperature gradient, but the reduction of the temperature gradient increases the chance of twinning and the formation of polycrystallization. Therefore, from the perspective of growth, it is more and more difficult to prepare large-size monocrystals with high-quality and low defects.

Chinese patent application CN 110541199 A discloses a method for preparing a high-quality SiC seed crystal with a diameter of 8 inches and above, comprising: cutting and splicing a SiC wafer or crystal with a size smaller than a target seed crystal; processing the spliced SiC seed crystal into a complete wafer shape by using an external grinding machine; performing lateral epitaxial growth on a growth surface of the spliced SiC seed crystal to fill a splicing crack of the seed crystal; performing homoepitaxy at the growth surface of the seed crystal to obtain a high-quality SiC seed crystal with a diameter of 8 inches and above, small total surface thickness variation, no cracks, and low defect density. This application represents a technical idea of joining them together by epitaxial growth.

In this way, it is necessary to control the reductive growth environment and join them together by epitaxial growth. Epitaxial growth requires epitaxial gases to be deposited at the joint by physical chemistry.

### Summary of the Invention

The present invention proposes a new idea to prepare large-size monocrystals with uniform electrical and dislocation parameters by solid-state joining of small size monocrystals.

In order to achieve the above object, the present invention adopts a method for preparing a large-size monocrystal, comprising the steps of:
material selection: selecting semiconductor single crystal blocks with generally similar physical properties and basically the same crystal orientation accuracy of the splicing plane;
splicing plane processing: subjecting the splicing plane of the semiconductor monocrystal block to orientation, polishing and acid washing treatments;
monocrystal splicing: abutting the splicing planes of the processed monocrystal blocks; and
monocrystal joining: applying a certain temperature and pressure in a vacuum clean environment or in a volatile atmosphere on the spliced monocrystal blocks to complete the preparation of the large-size monocrystal.

Further, the roughness Ra of the splicing plane polishing is 0.5 nm-10 nm; the flatness of the splicing plane is 5-15 microns; and after processing and polishing, the difference in crystal orientation between the splicing planes of the joined monocrystal block is less than 0.05.

Further, the semiconductor crystal block is obtained by cutting a single ingot or a plurality of ingots.

The splicing plane is a surface where a monocrystal is spliced with other monocrystals. When two monocrystals are spliced, each monocrystal has 1 splicing plane, and when a plurality of monocrystals are spliced, the monocrystal has at most 4 splicing planes.

The implementation principle of the present invention is: under a certain pressure and temperature, local microscopic plastic deformation is realized based on the consistency of crystal lattice, and the joining between monocrystals is realized through long-time interdiffusion of solid atoms. At the same time, after high-temperature vacuum treatment at a certain temperature, the oxide layer of the splicing plane is removed. The flat surface is easier to achieve the interface joining, achieving the joining and bonding between interface atoms better, and prevent the formation of holes.

It has the following advantageous effects: 1, the small-sized monocrystal blocks can be joined to prepare a large-size monocrystal; 2, the equipment is simple; 3, in the preparation process, there is no need to consider the problems that need to be paid attention to in the traditional single crystal growth process, such as twinning and polycrystallization; and 4, a monocrystal of any size can be prepared theoretically.

### Brief Description of the Drawings

Fig. 1 is an assembly view of a cylindrical monocrystal block by a combination clamp;
Fig. 2 is an assembling view of a cubic monocrystal block by a combination clamp;
Fig. 3 shows a bulk monocrystal solid-state joining device containing high temperature volatiles;
Fig. 4 is a schematic diagram showing the structure of a water-cooling furnace body in Fig. 3;
Fig. 5 is an assembly schematic diagram of a solid-joining chamber I of Fig. 3;
Fig. 6 is a bulk monocrystal solid-state joining device of a high temperature vacuum system;
Fig. 7 is a schematic diagram of an ingot and a planned position for cutting a crystal rod;
Fig. 8 is a schematic diagram of cutting monocrystal blocks from a crystal rod having twins and polycrystals;
Fig. 9 shows the splicing and assembly of monocrystal blocks cut from the same ingot;
Fig. 10 is a schematic diagram of cutting monocrystal blocks from different ingots and splicing the monocrystal blocks; and
Fig. 11 is a schematic illustration of cutting monocrystal blocks from different ingots.

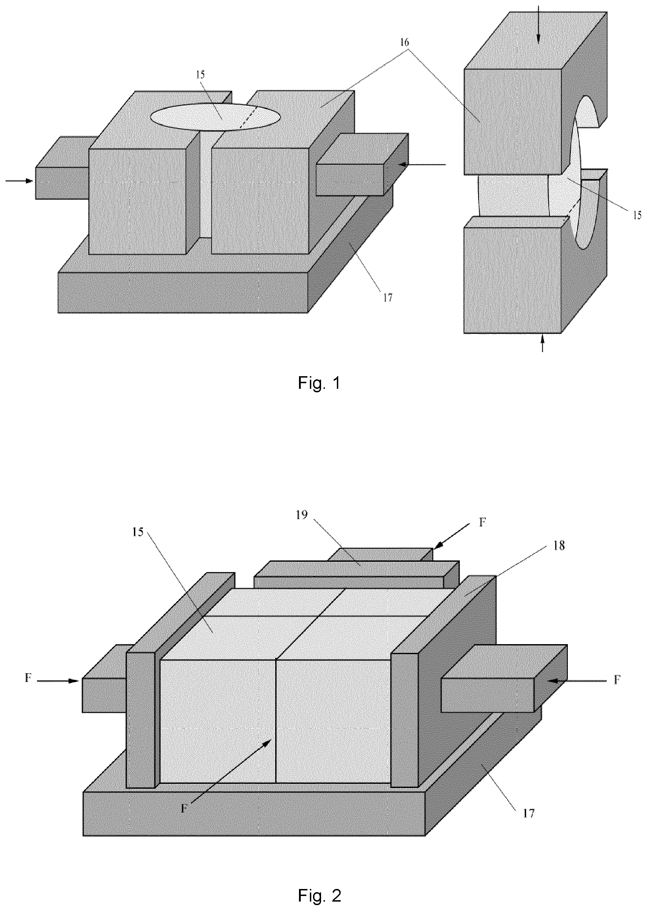

In Fig. 1, 15: monocrystal block combination; 16: circular fixture; and 17: chassis.

In Fig. 2, 18: cubic monocrystal block fixture I; 19: cubic monocrystal block fixture II. F indicates pressure application direction.

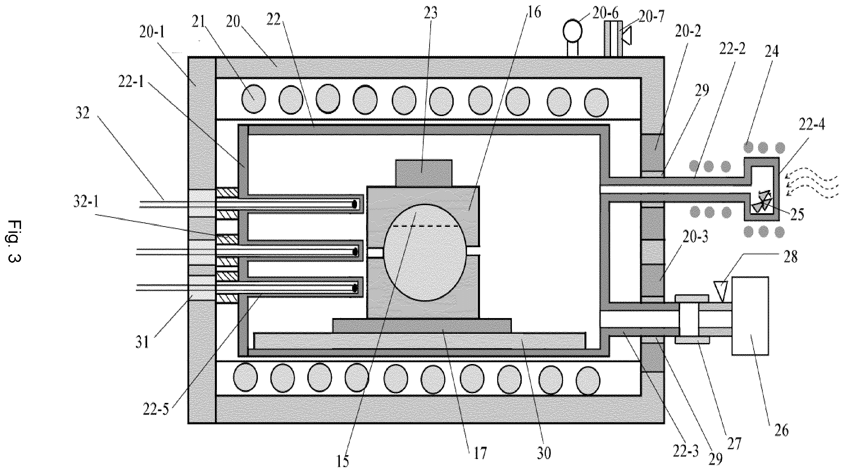

In Fig. 3, 20: water-cooling furnace body I; 20-1: side cover of furnace body I; 20-2: first flange of furnace body I; 20-3: second flange of furnace body I; 20-6: pressure gauge; 20-7: gas charging pipeline; 21: heating wire of furnace body I; 22: solid-joining chamber I main body; 22-1: solid-joining chamber I cover; 22-2: volatilization air pipe; 22-3: vacuum pipeline; 22-4: volatilization chamber; 23: stress pressing block; 24: auxiliary heating wire; 25: volatile; 26: vacuum system I; 27: vacuum rubber hose; 28: vacuum valve I; 29: flange rubber ring; 30: horizontal loading platform I; 31: thermocouple sealing ring; 32: thermocouple; 32-1: thermocouple protection tube. Dashed line with an arrow on the right side of the volatilization chamber 22-4 indicates cold air.

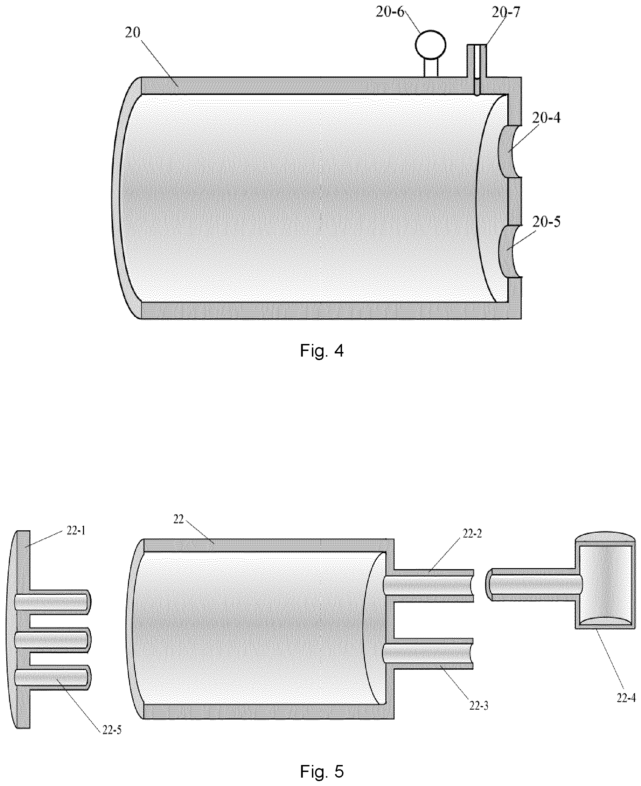

In Fig. 4, 20-4: first joining hole; and 20-5: second joining hole.

In Fig. 5, 22-5: built-in thermocouple tube I.

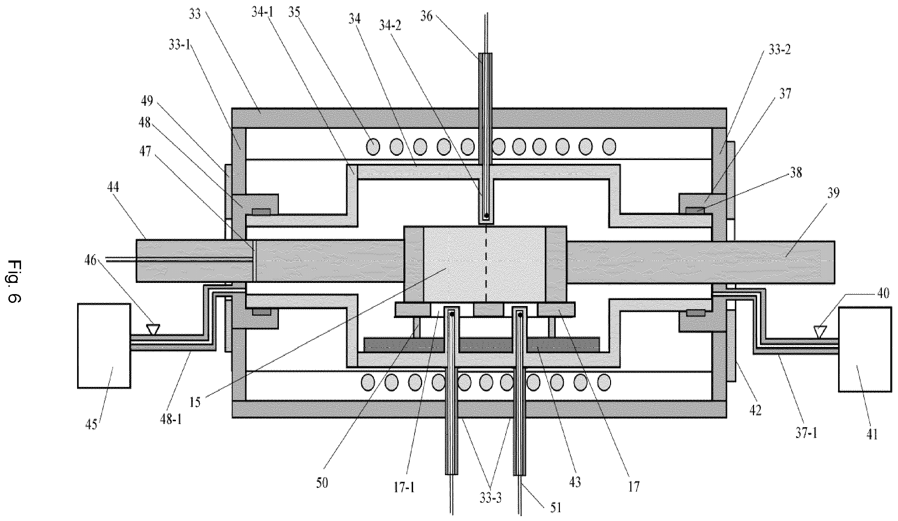

In Fig. 6, 17-1: chassis hole; 33: water-cooling furnace body II; 33-1: left side cover of furnace body II; 33-2: right side cover of furnace body II; 33-3: thermocouple hole of furnace body II; 34: solid-joining chamber II main body; 34-1: solid-joining chamber II cover; 34-2: built-in thermocouple tube II; 35: heating wire of furnace body II; 36: thermocouple ceramic tube of furnace body II; 37: right water-cooling flange; 37-1: right vacuum pipeline; 38: rubber ring; 39: right top column; 40: right vacuum valve; 41: right vacuum valve system; 42: right flange cover; 43: horizontal loading platform II; 44: left top column; 45: left vacuum valve system; 46: left vacuum valve; 47: strain gauge; 48: left water-cooling flange; 48-1: left vacuum pipeline; 49: left flange cover; 50: bracket; and 51: thermocouple.

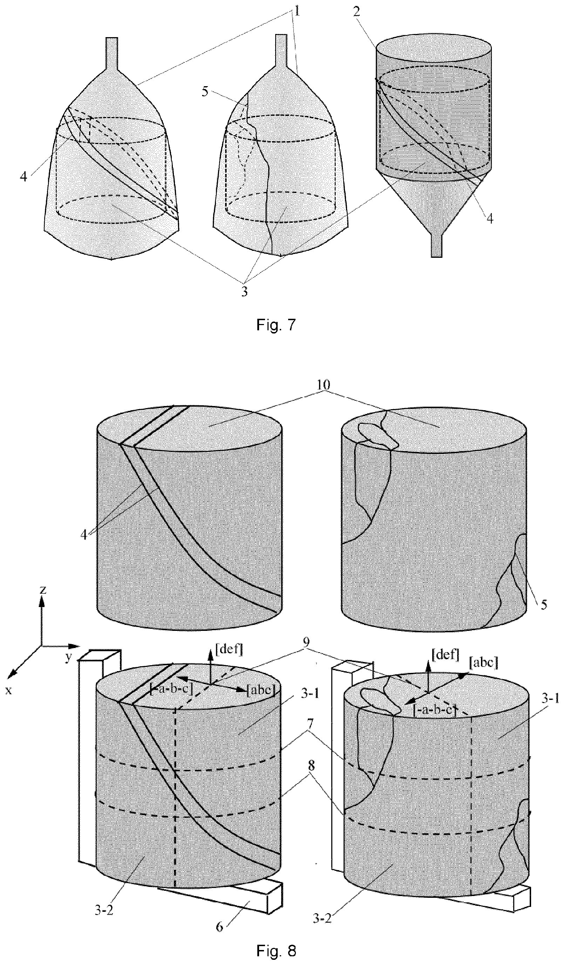

In Fig. 7, 1: LEC ingot; 2: VGF ingot; 3: crystal rod; 4: twin crystal boundary; and 5: polycrystal boundary.

In Figure 8, 4: twin crystal boundary; 5: polycrystal boundary; 6: binding resin; 7: cutting line trajectory I; 8: cutting line trajectory II; 9: cutting line trajectory III; 10: reference plane; 3-1: monocrystal block I; and 3-2: monocrystal block II.

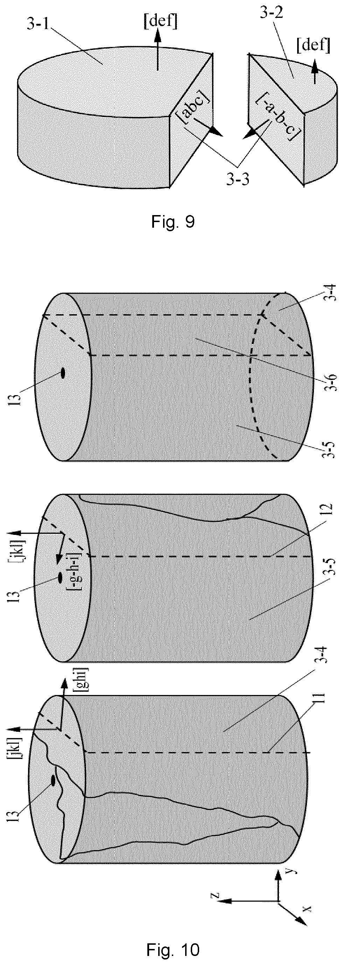

In Fig. 9, 3-3: splicing plane I.

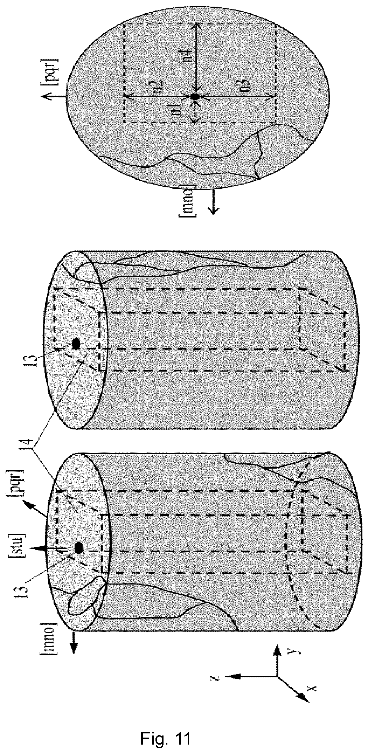

In Fig. 10, 11: cutting trajectory IV; 12: cutting trajectory V; 13: center of ingot/crystal rod; 3-4: monocrystal block III; 3-5: monocrystal block IV; and 3-6: splicing plane II.

In Fig. 11, 14: monocrystal block VI.

### Detailed Description of the Invention

Preparing a large-size monocrystal of the present invention is accomplished by the following steps.

### I. material selection: selecting semiconductor single crystal blocks with generally similar physical properties and basically the same crystal orientation accuracy of the splicing plane.

The "generally similar physical properties" means that the thermal field of crystal growth and growth conditions are the same, and the concentration of dopants in the melt and the crystal shape are similar.

The monocrystal block is free of defects such as twins and polycrystals.

Suitable monocrystal blocks may be selected from monocrystals that have been cut.

The present invention provides a method of obtaining a monocrystal block by cutting directly from an ingot.

Three ingots are shown in Fig. 7: two LEC ingots 1, and one VGF ingots 2. The ingots have twin and polycrystalline macro defects, and twin crystal boundary 4 and polycrystal boundary 5 represent the positions of the defects. Defects also exist in the crystal rod 3 cut from the ingot.
1. A semiconductor crystal block can be obtained by cutting a single ingot, as shown in Fig. 8. In the figure, the cylinders are crystal rods 3 (not shown) and the left and right parts represent crystal rods with two different macroscopic (twin or polycrystalline) defects at different locations.

The overall physical properties of one ingot are the same; Since the cutting plane is the splicing plane, it can ensure that the splicing planes of the two single crystal blocks have the same crystal orientation and high splicing accuracy.

During cutting, it is necessary to ensure that the interior of the cut monocrystal block is free from macroscopic defects, and at the same time, it is necessary to consider the utilization rate of materials.

The cutting method comprises:
A1, cutting the ingot 1 or 2 into the cylindrical crystal rod 3, bonding the crystal rod 3 on a resin block 6, machining a reference plane 10, and setting a coordinate system based on the reference plane 10;
A2, setting a cutting line trajectory I 7, a cutting line trajectory II 8 and a cutting line trajectory III 9;
wherein the crystal rod 3 is observe by naked eyes or an instrument; when setting the cutting trajectory, it is necessary to ensure that the two monocrystal blocks 3-1 and 3-2 are cut to avoid twin crystal boundary 4 or polycrystal boundary 5, and at the same time try to make the heights of the two single crystal blocks the same;
A3, cutting the crystal rod 3 along the cutting line trajectory I 7 and the cutting line trajectory II 8; and
A4, cutting the crystal rod 3 along the cutting line trajectory III 9;
wherein the machining does not cut through the resin block 6; the crystal rod 3 and the resin block can be in an integral state, and then the resin block 6 is removed by boiling with water;
through the above steps, monocrystal bulk I 3-1 and monocrystal bulk II 3-2 can be obtained. Steps A3 and A4 are in no particular order.

Since the crystal rod 3 is cut along the cutting line trajectory III 9, the monocrystal block I 3-1 and the monocrystal block II 3-2 can be spliced into a whole circle. In order to obtain a highly uniform monocrystal block, another monocrystal block may be machined according to the height of the thinner monocrystal block.

The monocrystal block I 3-1 and the monocrystal block II 3-2 are spliced through the splicing plane 3-3 to keep two crystals have the same [def] crystal orientation.

2. A semiconductor crystal block can be obtained by cutting a plurality of ingotss.

The present invention provides two methods.

Method 1 comprises: cutting two monocrystal blocks from two ingots and combining into a cylinder, as shown in Fig. 10.

The ingot with the same thermal field of crystal growth and growth conditions, similar dopant concentration and crystal shape in the melt are chosen.

During cutting, it is necessary to ensure that the interior of the cut monocrystal block is free from macroscopic defects, and the crystal direction accuracy of the splicing plane is basically consistent. The utilization rate of materials should also be considered.

The cutting method comprises:
B1, cutting cylindrical crystal rods 3 with the same diameter on two different ingots 1 or 2 respectively, and machining reference planes 10 respectively, the crystal orientation indexes of the two crystal rods 3 being the same;
B2, setting a cutting line trajectory IV 11 on one of the crystal rods 3, and cutting the crystal rod 3 along the cutting line trajectory IV 11 to obtain a monocrystal block III 3-4;
B3, testing the crystal orientation index [ghi] of the cut crystal plane on the monocrystal block III 3-4, and measuring a distance d from a center of a circle 13 of the reference plane 10 to the cutting line trajectory IV 11; and
B4, selecting a [-g-h-i] crystal plane on another crystal rod, designing the cutting line trajectory IV 11 at a position where the distance from the center 13 of the circle to the crystal plane is d, and cutting along the cutting line trajectory IV 11 to obtain monocrystal blocks IV 3-5

When the bulk crystal rods 3 are cut, the heights of the two crystal rods 3 are made uniform as much as possible.

The crystal rod 3 is observe by naked eyes or the instrument; when setting the cutting trajectory, it is necessary to ensure that the two monocrystal blocks 3-5 and 3-6 are cut to avoid the defect area represented by the curves in the figure.

The orientation indexes of the two crystal rods 3 are kept the same by orientation (measure crystal orientation) [jkh]).

Since the crystal rod 3 is cut along the cutting line trajectory IV 11, the monocrystal block I 3-4 and the monocrystal block II 3-5 can be spliced into a cylinder. In order to obtain a highly uniform monocrystal block, another monocrystal block may be machined according to the height of the monocrystal block with a lower height.

Method 2 comprises: cutting a plurality of monocrystal blocks from a plurality of ingots, and combining the monocrystal blocks into a cuboid or cube, as shown in Fig. 11.

The ingot with the same thermal field of crystal growth and growth conditions, similar dopant concentration and crystal shape in the melt are chosen.

During cutting, it is necessary to ensure that the interior of the cut monocrystal block is free from macroscopic defects, and the crystal direction accuracy of the splicing plane is basically consistent. The utilization rate of materials should also be considered.

The cutting method comprises:
C1, cutting cylindrical crystal rods 3 with the same diameter on different ingots 1 respectively, machining reference planes 10 respectively, and setting a coordinate system based on the reference plane 10, the crystal orientation index of each crystal rod 3 being the same; and
C2, cutting monocrystal blocks VI 14 from different crystal rods 3, the [mno] and [pqr] crystal orientations of all the monocrystal blocks being consistent, and the distances nl, n2, n3 and n4 of each face of each monocrystal block VI 14 from the center 13 of the circle of the reference plane of the crystal rod 3 being the same.

Step C2 can ensure a consistent cutting position on the crystal rod 3.

### II. splicing plane processing: subjecting the splicing plane of the semiconductor monocrystal block to orientation, polishing and acid washing treatments.

The crystal blocks cut by the above method do not need to be oriented.

For the crystal block not selected by the above method, the monocrystal is oriented by measuring the crystal orientation.

For the selected crystal block or the cut crystal block, the splicing plane thereof is subjected to polishing and pickling treatment, so that the roughness Ra of the splicing plane polishing is 0.5 nm-10 nm; the flatness of the splicing plane is 5-15 microns; and after processing and polishing, the difference in crystal orientation between the splicing planes of the joined monocrystal block is less than 0.05°.

### III. monocrystal splicing: abutting the splicing planes of the processed monocrystal blocks

As shown in Fig. 9, the monocrystal block I 3-1 and the monocrystal block II 3-2 are spliced through the splicing plane 3-3 to keep two crystals have the same [def] crystal orientation. In the rightmost drawing of Fig. 10, the monocrystal blocks III 3-4 and IV 3-5 can be spliced through the splicing plane II 3-6, so that the electrical uniformity and symmetry of the monocrystal substrate processed after the whole spliced crystal rod is joined can be ensured.

The monocrystal blocks cut in Fig. 11 can be spliced as shown in Fig. 2. A monocrystal block combination 15 can be formed after splicing the splicing planes of the processed monocrystal blocks. When splicing monocrystal blocks, it is necessary to ensure that the [mno] crystal orientation is joined to the splicing plane of the [-m-n-o] crystal orientation of another monocrystal block, and the [pqr] crystal orientation is joined to the splicing plane of the [-p-q-r] crystal orientation of another single crystal block. More monocrystal blocks can be joined. The splicing method can ensure the uniformity distribution between the wafers to be continuous.

### IV. monocrystal joining: applying a certain pressure in a vacuum clean environment or in a volatile atmosphere on the spliced monocrystal blocks to complete the preparation of the large-size monocrystal.

the preparation of a large-size monocrystal of the present invention is completed using a joining device.

The joining device comprises a water-cooling furnace, a solid-joining chamber hermetically placed in the water-cooling furnace, and a combination clamp placed in the solid-joining chamber. The combination clamp is configured to fix a plurality of crystal blocks, and a top column or a stress pressing block is used to apply pressure on the crystal blocks via the combination clamp. A heating wire surrounding the solid-joining chamber is arranged in the water-cooling furnace. A vacuum pipeline is in communication with the solid-joining chamber. A thermocouple is disposed proximate the combination clamp.

In order to fit differently shaped crystal blocks, the present invention contemplates two combination clamps.

Referring to Fig. 1, the combination clamp comprises two circular fixtures 16. The inner surface of the circular fixture has a circular arc shape that matches the shape of the crystal block. The arc has a radian of less than 180°. The combination clamp cooperates with the monocrystal block having a circular arc shape. If the two circular fixtures are closed, it is not possible to apply pressure to the crystal block through the fixtures, so that the radian of the circular arc of the circular fixtures 16 is less than 180°. The direction of the arrow is the direction of the applied pressure.

With reference to Fig. 2, a combination clamp matching a square crystal block comprises two sets of cubic monocrystal fixtures I 18 and II 19 arranged opposite to each other. The cubic monocrystal fixture has a planar inner surface and a length less than the combined length of the crystal blocks, so as to prevent the fixtures from abutting each other and avoid the inability to apply pressure to the crystal block through the fixture. The direction of the arrow is the direction of the applied pressure F. In the drawing, one cubic monocrystal block fixture II 19 is omitted in order to observe the crystal blocks therein and the splicing planes between the crystal blocks (represented by lines between crystal block combination).

The direction of pressure applied to the crystal block is perpendicular or nearly perpendicular to the splicing plane between crystal blocks.

Some semiconductor crystals have high temperature volatility, such as InP, GaAs, GaP, InAs, and CdZnTe, while some do not have this property, such as Si, Ge, and SiC.

The following examples are solid-state joining devices designed for two different types of semiconductor crystals described above.

Example 1, for solid-state joining of semiconductor crystals without high temperature volatility, Fig. 6 is referenced.

Firstly, the pressure F required for the splicing plane can be calculated and determined. The range of values is 0.8σ_{crss}<F<σ_{S}, where σ_{crss} is the critical shear stress of the joined semiconductor material at the temperature T2°C and σ_{S} is the compressive strength of the joined semiconductor material at the temperature T2°C. T2, as described below, is the highest temperature reached in the solid-state joining chamber during this process.

The crystal and the joining device are then assembled.

The horizontal loading platform II 43 is placed into the solid-joining chamber II main body 34.

The monocrystal block combination 15 is assembled, and each splicing plane is aligned. The monocrystal block combination is placed on a chassis 17 in combination with the circular fixture 16 or the cubic fixture I 18 and cubic fixture II 19.

The combined fixture is placed on the horizontal loading platform II 43 of the solid-joining chamber II main body 34. A bracket 50 is provided between the horizontal loading platform II 43 and the chassis 17 for positioning the monocrystal block combination 15 in the middle of the solid-joining chamber II main body 34.

A solid-joining chamber II cover 34-1 is welded to the solid-joining chamber II main body 34.

A right water-cooling flange 37 is assembled with a right top column 39 through a rubber ring 38. A left water-cooling flange 48 is assembled with the left top column 44 through the rubber ring 38. The right water-cooling flange 37 is assembled with a right hole of the solid-joining chamber II main body 34, and then the left water-cooling flange 48 is assembled with a left hole of the solid-joining chamber II main body 34.

The above system is loaded together into a water-cooling furnace body II 33, ensuring that a chassis hole 17-1 is aligned with a thermocouple hole 33-3 of furnace body II. A left flange cover 49 connects the left water-cooling flange 48 with the water-cooling furnace body II 33; and a right flange cover 42 connects the right water-cooling flange 37 and the water-cooling furnace body II 33.

The above system is loaded together into a water-cooling furnace body II 33, ensuring that a chassis hole 17-1 is aligned with a thermocouple hole 33-3 of furnace body II. The left flange cover 49 connects the left water-cooling flange 48, a left side cover 33-1 of furnace body II and water-cooling furnace body II 33 together. The right flange cover 42 connects the right water-cooling flange 37, a furnace body II right side cover 33-2 and the water-cooling furnace body II 33 together.

The thermocouple ceramic tube 36 of furnace body II is assembled into the furnace body. The thermocouple 51 is inserted into a built-in thermocouple tube II 34-2 on the solid-joining chamber II main body 34. The thermocouple ceramic tube 36 of furnace body II passes through the water-cooling furnace, the solid-joining chamber II main body 34, the horizontal loading platform II 43, and the chassis 17 to reach the vicinity of the combination clamp. Three thermocouples are shown, one above and two below the crystal block combination. In practice, the number may be increased or decreased as desired.

A right vacuum pipeline 37-1 is connected to a right vacuum valve system 41. The left vacuum pipeline 48-1 is connected to the left vacuum valve system 45.

In Fig. 6, if the combination clamp uses two sets of the cubic monocrystal block fixture I 18 and the cubic monocrystal block fixture II 19 which are oppositely arranged. Pressure can be applied in four directions. Only two directions are shown, and the other two directions can be implemented with the same structure.

The above operations can complete the assembly of the device.

The connection process is controlled as follows: 8.2 vacuuming the solid-joining chamber to 10⁻⁵ Pa;
8.3, heating the solid-joining chamber through the heating wire at a rate of 0.5-80°C/h, increasing the temperature to T1°C, and maintaining for 0.5-10 hours;
8.4, heating the solid-joining chamber to T2°C while applying pressure to the combination clamp through the right top column 39 and the left top column 44, the applied pressure being the value determined earlier;
8.5, maintaining the solid-joining chamber at T2°C at a constant temperature for 0.5-20 hours;
8.6, controlling a power of the heating wire, and cooling the solid-joining chamber at a rate of 0.5-80°C/h until it reaches room temperature; and
8.7, removing the pressures of the right top column 39 and the left top column 44 and charging to the solid-joining chamber to one atmosphere; and
8.8, opening the water-cooling furnace body, taking out and cutting the solid-joining chamber, and taking out the solid-state joined monocrystal.

Example 2, for solid-state joining of semiconductor crystals with high temperature volatility, Figs. 3-5 are referenced.

The pressure F required for the splicing plane can be determined. The range of values is 0.8σ_{crss}<F<σ_{S}, where σ_{crss} is the critical shear stress of the joined semiconductor material at the temperature T2°C and σ_{S} is the compressive strength of the joined semiconductor material at the temperature T2°C. T2, as described below, is the highest temperature reached in the solid-state joining chamber during this process.

The mass of the volatile m=P_{eqm}VM/RT is calculated according to a designed processing temperature and a space of the solid-joining chamber, where P_{eqm} is the saturated vapor pressure of the joined semiconductor material; V is the gaseous volume inside the solid-joining chamber (the internal gaseous volume of the solid-joining chamber is equal to the internal volume of the solid-joining chamber minus the volume of other objects within the solid-joining chamber, including the spliced monocrystal block, the horizontal loading platform 30, the thermocouple tube, the stress pressing block 23, etc.); M is the molar mass of the volatile; R is the Avogadro constant; and T is the maximum temperature inside the solid-joining chamber during this processing.

The crystal and the joining device are assembled.

Volatiles are weighed and loaded into a volatilization chamber 22-4.

The flange rubber ring 29 and the first flange 20-2 of furnace body I are fitted to (sleeved to) a volatilization air pipe 22-2. Then the volatilization chamber 22-4 and the volatilization air pipe 22-2 are welded together.

According to the pressure required by the splicing plane, a stress pressing block 23 is selected. The monocrystal blocks are assembled into a circular shape and clamped between two circular fixtures 16. The crystal block is placed vertically after being assembled, and the splicing plane is horizontal. Then, together with a bottom plate 17, the crystal blocks are placed on the horizontal loading platform I 30 of the solid-joining chamber I main body 22. The stress pressing block 23 is placed on the topmost end of the circular fixtures 16.

A solid-joining chamber I cover 22-1 is welded to the solid-joining chamber I main body 22.

The vacuum pipeline 22-3 is capped with a rubber stopper and filled with nitrogen or argon to one atmosphere.

The solid-joining chamber I main body 22 is loaded into the water-cooling furnace body I 20. The vacuum pipeline 22-3 is inserted into a second joining hole 20-5, and the two are connected using a second flange 20-3 of furnace body I. Meanwhile, the flange rubber ring 29 and the first flange 20-2 of the furnace body 1 are fitted to the first joining hole 20-4 of the water-cooling furnace body I body 20.

A thermocouple-connected side cover of furnace body I 20-1 is connected to the water-cooling furnace body I 20, at the same time, a thermocouple protection tube 32-1 is installed, and the thermocouple 32 is installed in the built-in thermocouple tube I 22-5. A thermocouple sealing ring 31 seals the water-cooling furnace.

The rubber stopper in the vacuum pipeline 22-3 is removed and the vacuum pipeline 22-3 is rapidly connected to a vacuum system I 26 via a vacuum rubber hose 27 to vacuum.

The above operations can complete the assembly of the device.

The connection process is controlled as follows: 9.3 vacuuming the solid-joining chamber to 10⁻⁵ Pa;
9.4, heating the solid-joining chamber through the heating wire at a rate of 0.5-80°C/h, increasing the temperature to T1°C, and maintaining for 0.5-10 hours; at the same time, performing air-cooling on the volatilization chamber 22-4;
9.5, heating the solid-joining chamber at a rate of 0.5-80°C/h by means of the heating wire, and increasing the temperature to T2°C; at the same time, stopping air-cooling on the volatilization chamber 22-4, and heating the volatilization chamber 22-4 and the volatilization air pipe 22-2 together by means of the auxiliary heating wire 24, and keeping the temperatures the same until the substances therein volatilizes completely; calculating the pressure in the solid-joining chamber according to the temperature of the volatilization chamber 22-4 in the process of increasing the temperature; and charging an inert gas with the same pressure into the water-cooling furnace body I 20 by means of the gas charging pipeline 20-7 to maintain the pressure balance inside and outside the solid-joining chamber;
9.6, maintaining the solid-joining chamber at T2°C at a constant temperature for 0.5-20 hours;
9.7, controlling a power of the heating wire, and cooling the solid-joining chamber at a rate of 0.5-80°C/h until it reaches room temperature; and
9.8, lowering the pressure of the water-cooling furnace through the gas charging pipeline 20-7, opening the water-cooling furnace, taking out and cutting the solid-joining chamber, and taking out the solid-state joined monocrystal.

In the above control process, T1 is 0.4Tm-0.6Tm; and T2 is 0.6Tm-0.9Tm, Tm being the melting point of the joined semiconductor material.

The above-mentioned two examples are intended to illustrate the technical solution of the present invention rather than to limit the same. According to practical requirements, the device obtained by combining different combinations of clamps, solid-joining chambers and water-cooling furnace bodies, and the space involved according to different connection materials, without departing from the essence of the technical solution, are all covered within the scope of the present invention.

## Claims

1. A method for preparing a large-size monocrystal, **characterized by** comprising the steps of:
material selection: selecting semiconductor single crystal blocks with generally similar physical properties and basically the same crystal orientation accuracy of the splicing plane;
splicing plane processing: subjecting the splicing plane of the semiconductor monocrystal block to orientation, polishing and acid washing treatments;
monocrystal splicing: abutting the splicing planes of the processed monocrystal blocks; and
monocrystal joining: applying a certain temperature and pressure in a vacuum clean environment or in a volatile atmosphere on the spliced monocrystal blocks to complete the preparation of the large-size monocrystal.

2. The method of claim 1, **characterized in that**, the roughness of the splicing plane is 0.5 nm-10 nm; the flatness of the splicing plane is 5-15 microns; and the crystal orientation difference between the splicing planes is less than 0.05°.

3. The method of claim 1, **characterized in that**, a semiconductor crystal block is obtained by cutting a single ingot, the cutting method comprising:
A1, cutting the ingot (1) into a cylindrical crystal rod (3), machining a reference plane (10), and setting a coordinate system based on the reference plane (10);
A2, setting a cutting line trajectory I (7), a cutting line trajectory II (8) and a cutting line trajectory III (9);
A3, cutting the crystal rod (3) along the cutting line trajectory I (7) and the cutting line trajectory II (8); and
A4, cutting the crystal rod (3) along the cutting line trajectory III (9) to obtain a monocrystal block I (3-1) and a monocrystal block II (3-2).

4. The method of claim 1, **characterized in that**, a semiconductor crystal block is obtained by cutting a plurality of ingots, the cutting method comprising method 1 or method 2:
wherein method 1 comprises:
B1, cutting cylindrical crystal rods (3) with the same diameter from two different ingots (1) respectively, machining reference planes (10) respectively, and maintaining crystal orientation indexes of the two crystal rods (3) to be the same by orientation;
B2, setting a cutting line trajectory IV (11) on one of the crystal rods (3), and cutting the crystal rod (3) along the cutting line trajectory IV (11) to obtain a monocrystal block III (3-4);
B3, testing the crystal orientation index [ghi] of the cut crystal plane on the monocrystal block III (3-4), and measuring a distance d from a center of a circle (13) of the reference plane (10) to the cutting line trajectory IV (11); and
B4, selecting a [-g-h-i] crystal plane on another crystal rod, designing the cutting line trajectory IV (11) at a position where the distance from the center of a circle (13) to the crystal plane is d, and cutting along the cutting line trajectory IV (11) to obtain monocrystal blocks IV (3-5); and
wherein method 2 comprises:
C1, cutting cylindrical crystal rods (3) with the same diameter from different ingots (1) respectively, and machining reference planes (10) respectively, the crystal orientation index of each ingot (3) being the same; and
C2, cutting monocrystal blocks VI (14) from different crystal rods (3), the [mno] and [pqr] crystal orientations of all the monocrystal blocks being consistent, and the distances nl, n2, n3 and n4 of each face of each monocrystal block VI (14) from the center of a circle (13) of the reference plane of the crystal rod (3) being the same.

5. The method of claim 1, **characterized in that**,
the preparation of a large-size monocrystal is completed using a joining device;
wherein the joining device comprises a water-cooling furnace, a solid-joining chamber hermetically placed in the water-cooling furnace, and a combination clamp placed in the solid-joining chamber, wherein the combination clamp is configured to fix a plurality of crystal blocks, and a top column or a stress pressing block is used to apply pressure on the crystal blocks via the combination clamp;
a heating wire surrounding the solid-joining chamber is arranged in the water-cooling furnace;
a vacuum pipeline is in communication with the solid-joining chamber; and
a thermocouple is disposed proximate the combination clamp.

6. The method of claim 5, **characterized in that**,
the water-cooling furnace comprises a water-cooling furnace body II (33), a left side cover (33-1) of furnace body II and a right side cover (33-2) of furnace body II;
the solid-joining chamber comprises a solid-joining chamber II main body (34), and a solid-joining chamber II cover (34-1), the solid-joining chamber II main body (34) and the solid-joining chamber II cover (34-1) enclosing an inner cavity;
the water-cooling furnace and the solid-joining chamber are connected via a right water-cooling flange (37) and a left water-cooling flange (48); and
wherein the combination clamp in the solid-joining chamber applies pressure by a right top column (39) and a left top column (44), both positioned with a cold water flange.

7. The method of claim 5, **characterized in that**,
a volatilization chamber (22-4) is in communication with the solid-joining chamber via a volatilization air pipe (22-2);
wherein the water-cooling furnace comprises a water-cooling furnace body I (20), a side cover (20-1) of furnace body I, a first flange (20-2) of furnace body I for positioning a volatilization air pipe(22-2) being provided in a first joining hole (20-4), and a second flange (20-3) of furnace body I for positioning a vacuum pipe (22-3) being provided in a second joining hole (20-5);
the solid-joining chamber comprises a solid-joining chamber I main body (22) and a solid-joining chamber I cover (22-1), the solid-joining chamber I main body (22) and the solid-joining chamber I cover (22-1) enclosing an inner cavity;
the water-cooling furnace is further provided with a gas charging pipeline (20-7) with a valve; and
an auxiliary heating wire (24) is provided around the volatilization chamber (22-4) and the volatilization air pipe (22-2).

8. The method of claim 6, **characterized in that**,
determining the pressure required by the splicing plane;
the monocrystal joining comprises the following steps:
8.1, assembling the crystals and the joining device;
8.2, vacuuming the solid-joining chamber to 10⁻⁵ Pa;
8.3, heating the solid-joining chamber through the heating wire at a rate of 0.5-80°C/h, increasing the temperature to T1°C, and maintaining for 0.5-10 hours;
8.4, heating the solid-joining chamber to T2°C while applying pressure to the combination clamp through the right top column (39) and the left top column (44);
8.5, maintaining the solid-joining chamber at T2°C at a constant temperature for 0.5-20 hours;
8.6, controlling a power of the heating wire, and cooling the solid-joining chamber at a rate of 0.5-80°C/h until it reaches room temperature;
8.7, removing the pressures of the right top column (39) and the left top column (44) and charging to the solid-joining chamber to one atmosphere; and
8.8, opening the water-cooling furnace body, taking out and cutting the solid-joining chamber, and taking out the solid-state joined monocrystal.

9. The method of claim 7, **characterized in that**,
determining the pressure required by the splicing plane;
the mass of the volatile m=P_{eqm}VM/RT is calculated according to a designed processing temperature and a space of the solid-joining chamber, where P_{eqm} is the saturated vapor pressure of the joined semiconductor material; V is the gaseous volume inside the solid-joining chamber; M is the molar mass of the volatile; R is the Avogadro constant; and T is the maximum temperature inside the solid-joining chamber during this processing;
the monocrystal joining comprises the following steps:
9.1, assembling the crystals and the joining device;
9.2, applying pressure on the combination clamp;
9.3, vacuuming the solid-joining chamber to 10⁻⁵ Pa;
9.4, heating the solid-joining chamber through the heating wire at a rate of 0.5-80°C/h, increasing the temperature to T1°C, and maintaining for 0.5-10 hours; at the same time, performing air-cooling on the volatilization chamber (22-4);
9.5, heating the solid-joining chamber at a rate of 0.5-80°C/h by means of the heating wire, and increasing the temperature to T2°C; at the same time, stopping air-cooling on the volatilization chamber (22-4), and heating the volatilization chamber (22-4) and the volatilization air pipe(22-2) together by means of the auxiliary heating wire (24), and keeping the temperatures the same until the substances therein volatilizes completely; calculating the pressure in the solid-joining chamber according to the temperature of the volatilization chamber (22-4) in the process of increasing the temperature; and charging an inert gas with the same pressure into the water-cooling furnace body I (20) by means of the gas charging pipeline (20-7) to maintain the pressure balance inside and outside the solid-joining chamber;
9.6, maintaining the solid-joining chamber at T2°C at a constant temperature for 0.5-20 hours;
9.7, controlling a power of the heating wire, and cooling the solid-joining chamber at a rate of 0.5-80°C/h until it reaches room temperature; and
9.8, lowering the pressure of the water-cooling furnace through the gas charging pipeline (20-7), opening the water-cooling furnace, taking out and cutting the solid-joining chamber, and taking out the solid-state joined monocrystal.

10. The method of claim 8 or 9, **characterized in that**,
T1 is 0.4Tm-0.6Tm; and T2 is 0.6Tm-0.9Tm, Tm being the melting point of the joined semiconductor material; and
the range of values of the pressure F required for the splicing plane is: 0.8σ_{crss}<F<σ_{S}, where σ_{crss} is the critical shear stress of the joined semiconductor material at the temperature T2°C and σ_{S} is the compressive strength of the joined semiconductor material at the temperature T2°C.
